# EUROPEAN PATENT APPLICATION

(11) **EP 4 656 270 A1**
(43) Date of publication of application: **03.12.2025**
(21) Application number: 25173223.6
(22) Date of filing: 29.04.2025
(51) Int. Cl.: B01D 46/00, B01D 46/10, B01D 46/58, H05K 7/20

(54) **AIR FILTERING DEVICE FOR VENTILATION UNITS OF INDUSTRIAL ELECTRIC CABINETS**

(30) Priority: 27.05.2024 IT 202400011920
(71) Applicant: Fandis S.p.A., 20840 Borgo Ticino NO (IT)
(72) Inventor: Affuso, Marco, 20840 Borgo Ticino (NO) (IT)
(74) Representative: Garavelli, Paolo

(57) **Abstract**

An air filtering device for ventilation units of industrial electrical cabinets is described, comprising an air filter supported by a support frame (1), the air filter equipped with a filter cloth, the support frame (1) equipped with a cover (2), wherein the support frame (1) comprises at least one lateral grille (3) hooked to the body of the frame by means of staggered hooks (4) and a hinge-pin system (5) which allows the rotation of the grille itself; the device comprises spacer adapters (11) which allow the installation of radial fans with different pitch heights, offering flexibility for the installation of various types of fans.

## Description

The present invention relates to an air filtering device for ventilation units of industrial electrical cabinets.

In general, the present invention relates to details of removable closures, covers, caps or filter heads, filters or filtration processes modified to separate particles from gases or vapors with additional separation or treatment functions, and auxiliary equipment or operation thereof.

In particular, the present invention relates to suction grilles, filters, dust separation, adapted cleaning for elastic fluid pumps, especially for fans, such as fan guards, and ventilation grilles.

The state of the art is represented by EP1843652B1 regarding an air filtering device for ventilation units used in industrial enclosures, such as electrical cabinets and control panels. This device comprises an air filter mounted in a support frame that allows easy access for maintenance and replacement of the filter itself. The structure is made of plastic materials to ensure resistance, lightness and ease of production. The design includes several obliquely arranged fins to improve airflow and protect the filter from large particles. These fins also allow safe and quick installation of the filter, reducing the risk of damage during maintenance. The device is designed to be compatible with various types of fans, providing flexibility in application in different industrial configurations. Furthermore, the filter mounting system is designed to minimize airflow resistance, thus ensuring an optimal efficiency of the ventilation system. The combination of these elements makes the filter device described in EP1843652B1 particularly suitable for industrial applications where frequent maintenance and long component life are required. The patent also describes the integration of the filter device into various industrial environments, demonstrating its versatility and adaptability. The modular structure of the device also allows individual parts to be replaced without having to remove the entire system, reducing downtime and improving overall operating efficiency. The focus on ease of maintenance, together with the use of highquality materials, ensures that the device can operate effectively even in harsh environmental conditions, such as those found in many industrial settings. The ability to protect internal components from external contaminants further helps extending the service life of the equipment, reducing the need for frequent and costly replacements.

Documents US-A1-2020/187382 and US-B1-6 284 011 describe air filtering devices according to the preamble of Claim 1.

The above state of the art does not solve a number of technical issues. In particular: there is no side grille system that allows for maintenance without having to remove the entire cover; the design of specific spaces for the capacitors is not addressed, leaving potential positioning and stability issues; the lack of an integrated system, such as the 4-pole connector, limits safety and efficiency in cable management; the possibility of adapting the installation to different sized fans via spacer adapters is not mentioned, reducing the flexibility of the system; the lack of a cloth holder that ensures IP54 compliance may affect protection against dust and water, limiting applicability in harsh industrial environments.

The solutions to the above technical problems are implemented through: the introduction of a side grille that allows maintenance operations to be carried out without having to remove the entire cover, facilitating access to the internal components and improving operating efficiency; the design of specific corners inside the tower to house the condensers, ensuring a stable and safe positioning, reducing the risk of damage and improving cooling efficiency; the implementation of an integrated 4-pole connector that improves safety and efficiency in cable management, reducing the possibility of errors during wiring and protecting the cables themselves from accidental damage; the use of spacer adapters that allow the installation of radial fans of different sizes, offering greater flexibility and adaptability of the system to different operating needs; the introduction of a cloth holder that ensures IP54 compliance, improving protection against dust and water, making the system suitable for harsh industrial environments and ensuring the safety of internal components.

Object of the present invention is solving the above prior art problems by providing an air filtering device for ventilation units of industrial electrical cabinets which is equipped with a side grille which allows maintenance operations without removing the entire cover.

An additional object is providing an air filtering device for industrial electrical cabinet ventilation units that can house capacitors in a stable and safe manner.

An additional object is providing an air filtration device for industrial electrical cabinet ventilation units intended to offer flexibility in installing fans through the use of spacer adapters.

An additional object is providing an air filtering device for ventilation units of industrial electrical cabinets to improve protection against dust and water by introducing a cloth holder that ensures IP54 compliance and allows the filter cloth to be replaced directly from the outside without having to remove the cover.

An additional object is integrating staggered hooks that improve the hold of the side grille and facilitate its assembly.

An additional object is providing a hinge-pin system that allows the rotation and assembly of the side grille to the tower body.

An additional object is including a cloth holder that fits into the specially created slots on the body of the tower.

An additional object is including a containment dam in the tower body which improves protection against dust and water.

An additional object is providing flaps on the lid that hold the cloth holder and filter cloth in place, compensating for deformation of the cloth itself.

An additional object is designing four corners to accommodate the capacitors, keeping them safe from rotating, dangerous or live parts.

An additional object is providing a capacitor holder that holds the capacitors in place.

A further object is allowing the installation of the backward curved radial fan on a support plate fixed to the internal columns of the tower body.

An additional object is providing spacer adapters that allow the installation of fans with pitch heights between 100 mm and 130 mm.

A further object is providing a method for releasing the side grille from the body of the tower using a flat screwdriver, allowing the rotation of the side grille due to the hinge-pin system.

The above and other objects and advantages of the invention, as will result from the following description, are achieved with an air filtering device for ventilation units of industrial electrical cabinets, such as that described in claim **1.** Preferred embodiments and non-trivial variations of the present invention form the subject matter of the dependent claims.

It is understood that all attached claims form an integral part of this description.

It will be immediately obvious that countless variations and modifications can be made to what is described (for example relating to shape, dimensions, arrangements and parts with equivalent functionality) without departing from the scope of the invention as appears from the attached claims.

The present invention will be better described by some preferred embodiments, provided by way of example and not by way of limitation, with reference to the attached drawings, in which:

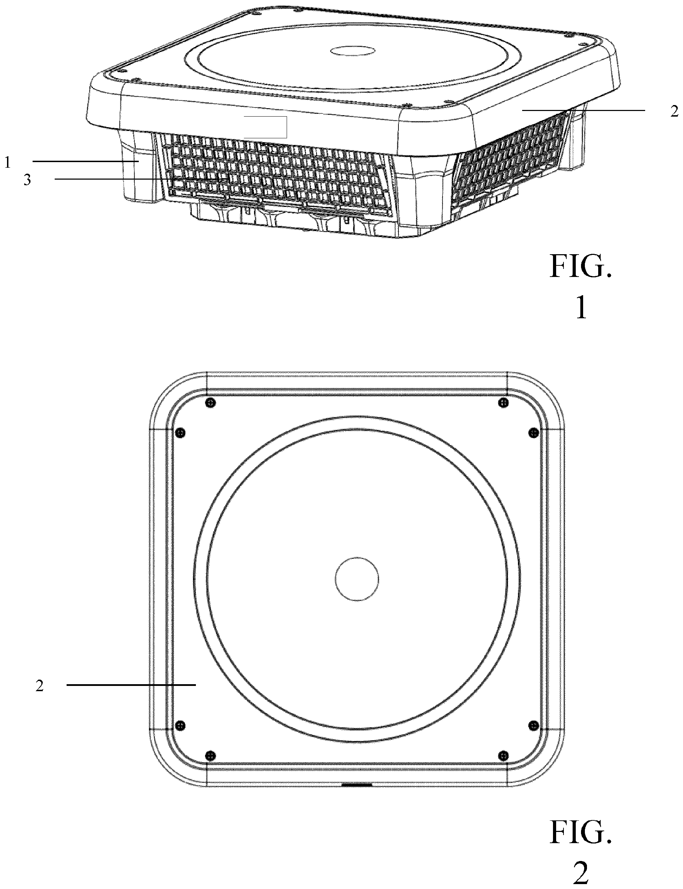

- FIG. 1 shows a perspective view of an embodiment of the air filtering device for ventilation units of industrial electrical cabinets, according to the present invention;
- FIG. 2 shows a plan view of FIG. 1;

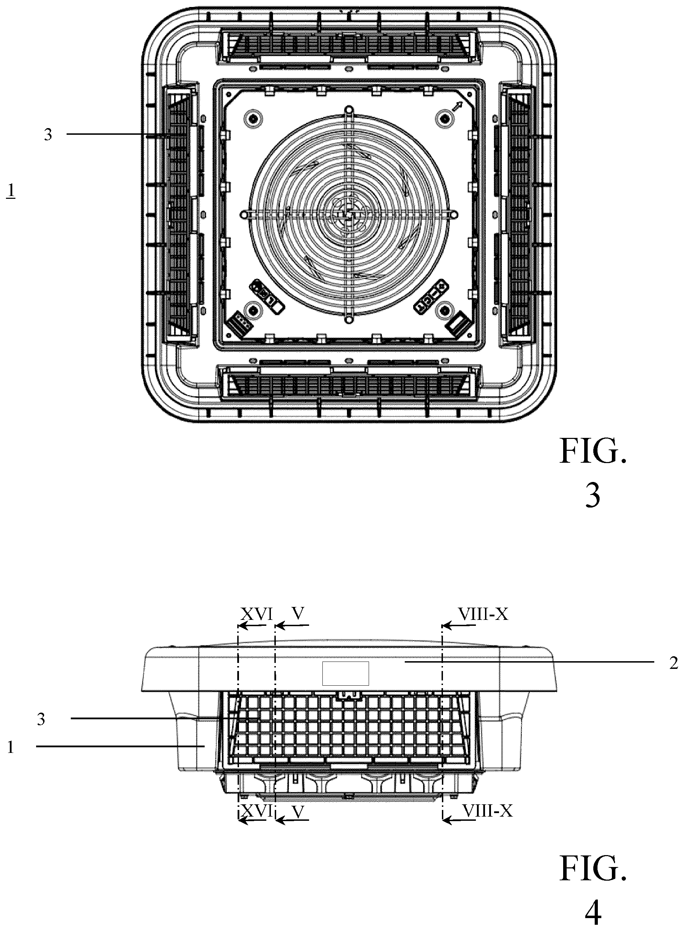

- FIG. 3 shows a plan view of the supporting frame of an embodiment of the air filtering device for ventilation units of industrial electrical cabinets, according to the present invention;
- FIG. 4 shows a front view of the device of an embodiment of the air filtering device for ventilation units of industrial electrical cabinets, according to the present invention;

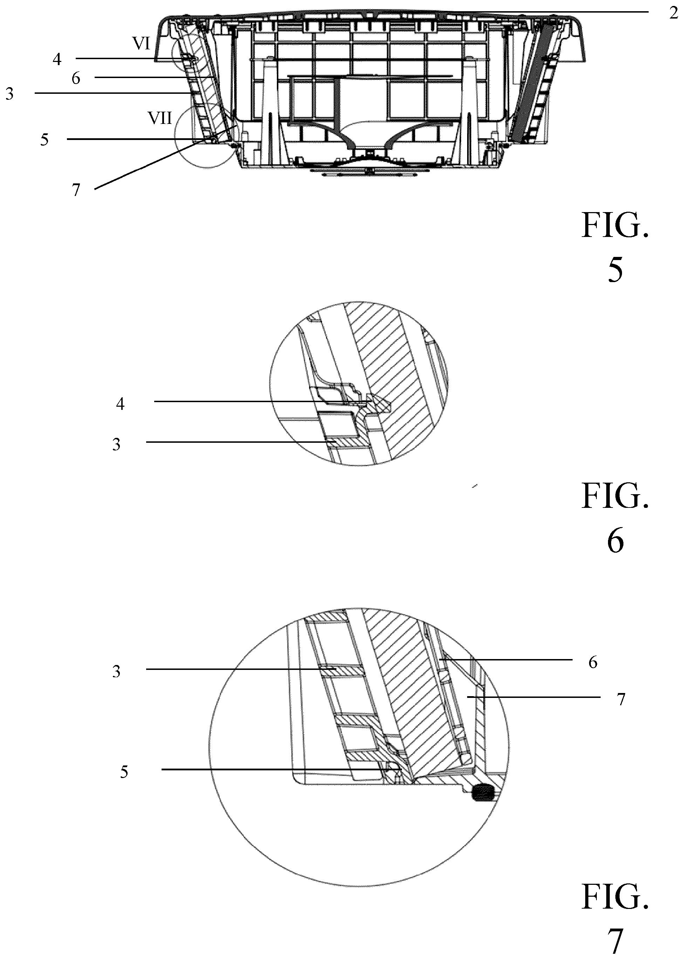

- FIG. 5 shows a sectional view along line VV of FIG. 4;
- FIG. 6 shows a sectional view of portion VI of FIG. 5;
- FIG. 7 shows a sectional view of portion VII of FIG. 5;

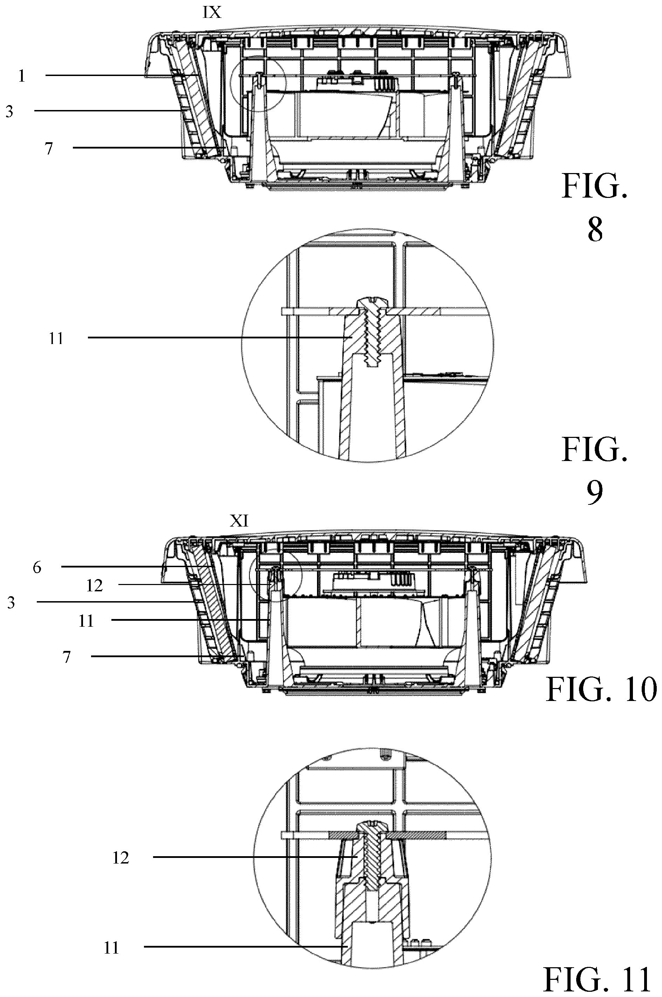

- FIG. 8 shows a sectional view along line VIII-VIII of FIG. 4;
- FIG. 9 shows a sectional view of portion IX of FIG. 8;
- FIG. 10 shows a sectional view along line XX of FIG. 4;
- FIG. 11 shows a sectional view of portion XI of FIG. 10;

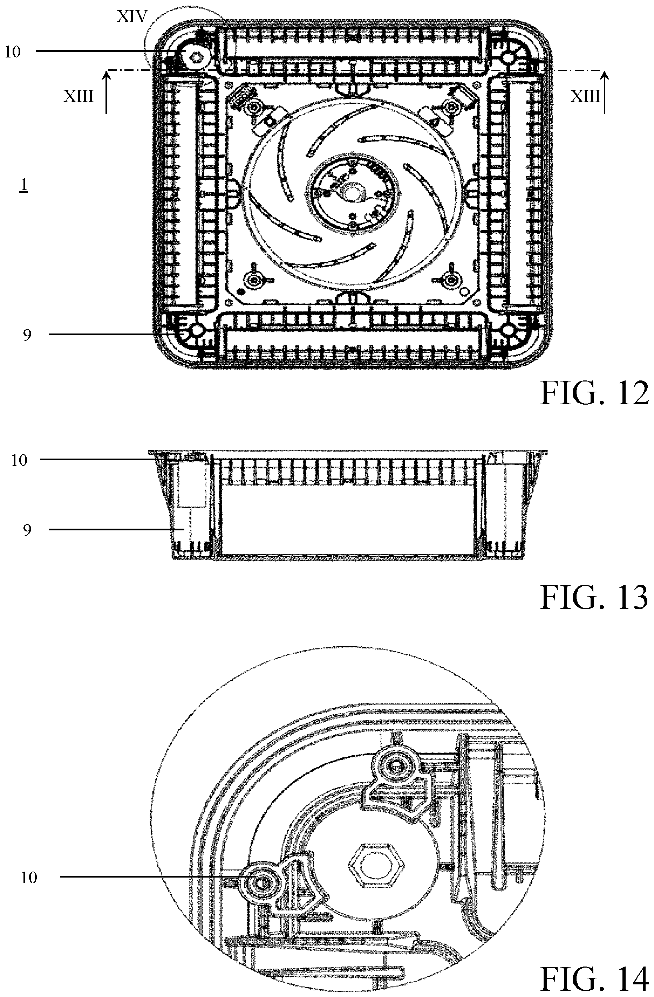

- FIG. 12 shows a further plan view of the support frame of an embodiment of the air filtering device for ventilation units of industrial electrical cabinets, according to the present invention;
- FIG. 13 shows a sectional view along line XIII-XIII of FIG. 12;
- FIG. 14 shows a sectional view of portion XIV of FIG. 12;

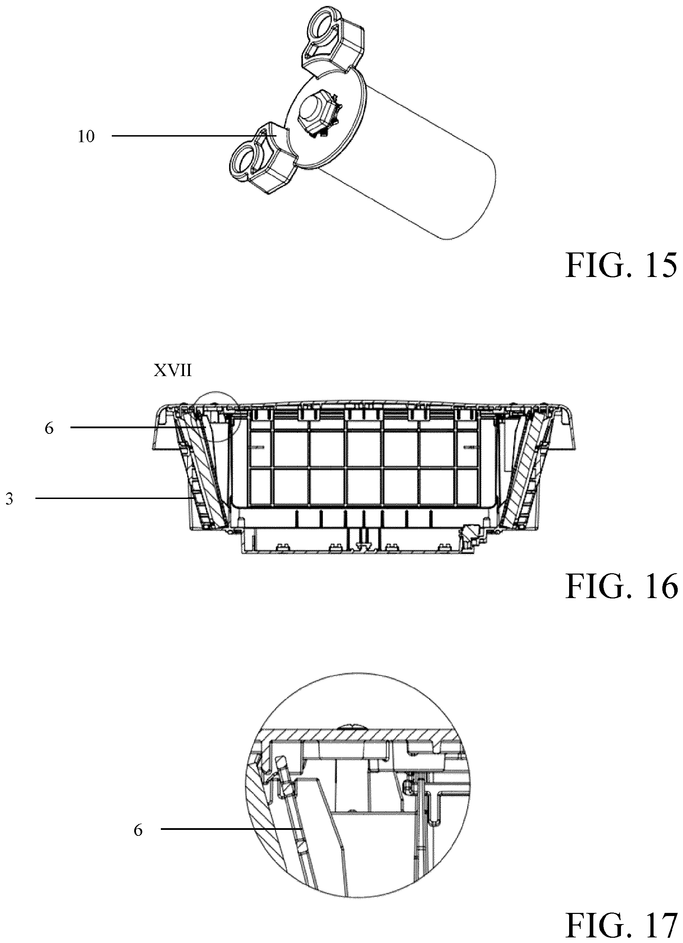

- FIG. 15 shows a perspective view of the capacitor holder of an embodiment of the air filtering device for ventilation units of industrial electrical cabinets, according to the present invention;
- FIG. 16 shows a sectional view along line XVI-XVI of FIG. 4;
- FIG. 17 shows a sectional view of portion XVII of FIG. 16;

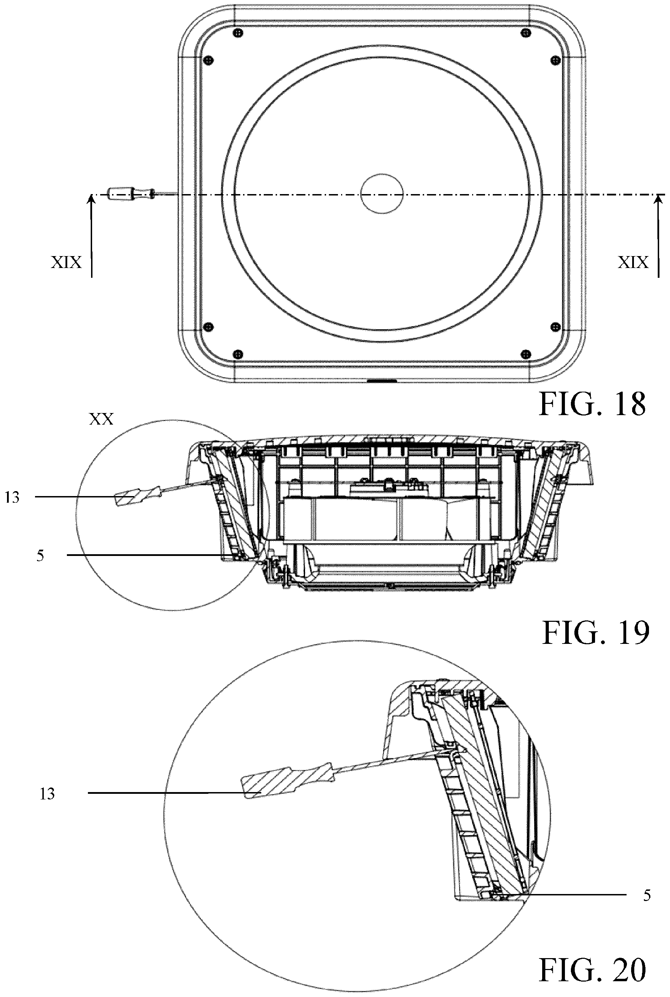

- FIG. 18 shows a further plan view of FIG. 1;
- FIG. 19 shows a sectional view along line XIX-XIX of FIG. 18;
- FIG. 20 shows a sectional view of portion XX of FIG. 19;

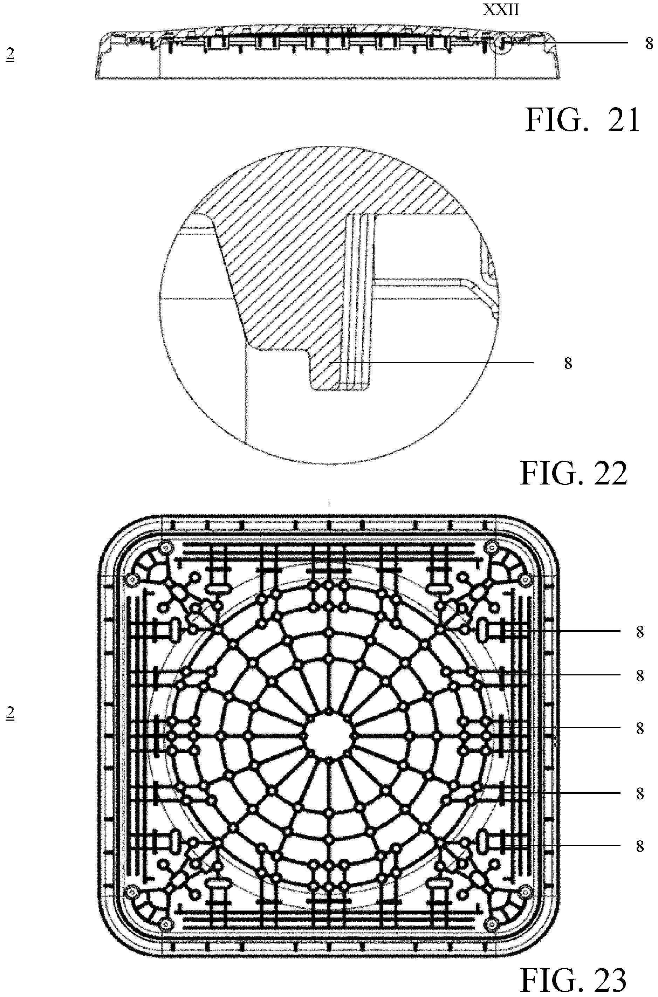

- FIG. 21 shows a front sectional view of the cover of an embodiment of the air filtering device for ventilation units of industrial electrical cabinets, according to the present invention;
- FIG. 22 shows a sectional view of portion XXII of FIG. 21; and
- FIG. 23 shows an internal plan view of the cover of an embodiment of the air filtering device for ventilation units of industrial electrical cabinets, according to the present invention.

Referring to the figures, it can be noted that an air filtering device for ventilation units of industrial electrical cabinets, comprises an air filter supported by a support frame 1. The air filter is provided with a filter cloth, the support frame 1 is provided with a cover 2.

Advantageously, the support frame 1 comprises at least one lateral grille 3 attached to the body of the frame by means of staggered hooks 4 and a hinge-pin system 5 which allows the grille itself to rotate, to permit maintenance and replacement of the filter cloth without removing the cover 2.

A cloth holder 6 inserted in the seats specially made on the body, with the filter cloth, not shown, placed between the cloth holder 6 and the side grille 3, serve to guarantee high aeraulic performance and IP54 compliance.

A containment dam 7 is designed to collect and manage fluids passing through the filter cloth, ensuring that fluids do not reach sensitive components within the industrial electrical enclosure. The containment dam 7 is shaped as a raised structure or lip surrounding the filter cloth area, creating a physical containment to prevent dust and water from entering the ventilation system. The specific shape of the dam 7 is designed to follow the contour of the filter cloth and cloth holder 6, providing effective protection.

Wings 8 on the lid 2 hold the cloth holder 6 and the filter cloth in place, compensating for the deformation of the cloth itself.

Specific corners 9 designed to accommodate the capacitors, secured to respective capacitor holders 10 via the capacitor's threaded shank, keep the capacitors safe from rotating, dangerous or live parts, with the capacitor holders 10 securing the capacitors in place.

Spacer adapters 11 allow the installation of radial fans with different pitch heights, offering flexibility for the installation of various types of fans.

It is provided to use a device to release the side grille 3 from the body of the tower using a 12-mm flat screwdriver, allowing the rotation of the side grille 3 due to the hinge-pin system 5.

The plastic tower is a device used in combination with one or more air filters to ensure air exchange inside enclosures such as electrical cabinets and panels. Installed on the top of these enclosures, it allows the extraction of hot air, maintaining optimal temperature conditions. The novelty of the project lies in the construction of the body and cover entirely in polymeric materials, making the tower the first of its kind on the market. The differences between the "TP22", "TP25" and "TP28" models concern exclusively the size of the installed fan. The maximum size is 481 x 481 x 188.8 mm.

The project includes the addition of four open side windows on the tower body and the implementation of a side grille. This solution facilitates assembly by allowing assembly operators to easily access awkward areas. In addition, the "zipper-staggered hooks" coupling system absorbs shocks better and allows the use of more rigid polymer materials. Three hooks, with the central one staggered, improve the holding of the side grille even in the event of lateral impacts. This design also allows the replacement of filter cloths directly from the outside, without having to open the tower cover.

Another innovation is the introduction of a cloth holder to support the filter cloth, which is necessary to maintain high airflow performance and IP54 protection rating. The "dam" collects water that passes through the filter cloth, expelling it through dedicated openings. The cloth holder can be easily installed during assembly and maintenance, and the "filter cloth and cloth holder locking tabs" keep the filter cloth in the correct position, preventing access to dangerous parts.

The design also includes four corners designed to accommodate the condensers, keeping them stable and not disturbing the airflow. The stability of the condenser is guaranteed by the "condenser holder", which avoids aerodynamic performance losses and positions the condenser safely, avoiding damage and dangers during maintenance.

The tower uses a 4-pole connector fixed in the body, with a separate plug and socket body. This configuration protects the power and control signal cables, prevents contact with the test ball used in the Ball Impact Test, and reduces the likelihood of wiring errors.

Finally, the project includes spacer adapters for the tower columns, which allow the installation of radial fans with different heights. This solution offers great flexibility in the use of radial fans of various sizes and facilitates production by changing only the printing matrices.

## Claims

1. Air filtering device for ventilation units of industrial electrical cabinets, comprising an air filter supported by a support frame (1), the air filter equipped with a filter cloth, the support frame (1) equipped with a cover (2), wherein the support frame (1) comprises at least one lateral grille (3) hooked to the body of the frame by means of staggered hooks (4) and a hinge-pin system (5) which allows the rotation of the grille itself,
**characterized in that** it includes spacer adapters (11) which allow the installation of radial fans with different pitch heights, offering flexibility for the installation of various types of fans.

2. Device according to claim 1, **characterized in that** it comprises a cloth holder (6) inserted into the seats specifically created on the body, with the filter cloth placed between the cloth holder (6) and the lateral grille (3), to guarantee high aeraulic performance and IP54 compliance.

3. Device according to one of the preceding claims, **characterized in that** it comprises a containment dam (7) designed to collect and manage fluids passing through the filter cloth, ensuring that they do not reach sensitive components inside the industrial electrical cabinet, shaped as a raised structure or edge surrounding the filter cloth area, creating a physical containment to prevent dust and water from entering the ventilation system, the specific shape of the dam (7) being designed to follow the contour of the filter cloth and the cloth holder (6), ensuring effective protection.

4. Device according to one of the previous claims, **characterized in that** it comprises fins (8) on the lid (2) which hold the cloth holder (6) and the filter cloth in position, compensating for the deformation of the cloth itself.

5. Device according to one of the preceding claims, **characterized in that** it comprises specific corners (9) designed to accommodate capacitors, fixed to respective capacitor holders (10) via the threaded shank of the capacitor, keeping them safe from rotating, dangerous or live parts, with the capacitor holders (10) fixing the capacitors in position.
